# EUROPEAN PATENT APPLICATION

(11) **EP 4 531 506 A1**
(43) Date of publication of application: **02.04.2025**
(21) Application number: 24198781.7
(22) Date of filing: 06.09.2024
(51) Int. Cl.: H05K 7/02, H05K 7/14

(54) **CIRCUIT BOARD ASSEMBLY AND HOUSEHOLD APPLIANCE**

(30) Priority: 28.09.2023 CN 202322665214 U
(71) Applicant: Diehl AKO Stiftung & Co. KG, 88239 Wangen (DE)
(72) Inventor: Zhang, Youfu, Nanjing, 211100 (CN); Li, Da, Nanjing, 211100 (CN); Cui, Fengqun, Nanjing, 211100 (CN)
(74) Representative: Diehl Patentabteilung

(57) **Abstract**

The present invention relates to a circuit board assembly, wherein the circuit board assembly comprises a main circuit board and at least one sub-circuit board, wherein the main circuit board and the at least one sub-circuit board are electrically and mechanically connected to each other, the sub-circuit board can stand upright on the main circuit board, and wherein an edge connector is provided on the free edge of the sub-circuit board. The circuit board assembly has a more compact configuration on one hand, which helps the circuit board assembly to develop towards miniaturization and weight reduction; on the other hand, the circuit board assembly can use the edge connector constructed on the sub-circuit board instead of the connection terminal as the interface for electrical connection with external devices, thereby having a lower production cost. The present invention also relates to a household appliance.

## Description

The invention relates to a circuit board assembly and a household appliance.

In the prior art, it is known to use glue potting technology to protect circuit boards and components located on the circuit boards, especially the plug-in portion between the components and the circuit boards from influences of the environment. In the glue potting technology, the circuit board is overall enclosed by encapsulating materials, thereby improving the integrity and strength of the circuit board and the components, improving the waterproof and dustproof performance of the circuit board assembly, and ensuring the safety of use and the life of the circuit board assembly. In general, in order to connect the circuit board with external equipment, a connection terminal is provided on the circuit board. The connection terminal has a shell wall surrounding the connection area (such as contact pins or a socket), the shell wall can prevent the encapsulating material from entering the connection area during glue potting, so that the circuit board can still be connected to external equipment via the connection terminal after glue potting.

However, on one hand, the connection terminal occupies a relatively large area of the circuit board, limiting the development of the circuit board assembly towards miniaturization and weight reduction. On the other hand, the relatively high manufacturing or purchasing costs of the connection terminals also lead to increase in the total production cost of the circuit board assembly.

The object of the invention is to provide a circuit board assembly and a household appliance, by means of which at least some of the drawbacks in the prior art can be overcome.

The first aspect relates to a circuit board assembly, which comprises a main circuit board and at least one sub-circuit board, wherein the main circuit board and the at least one sub-circuit board are electrically and mechanically connected to each other, the sub-circuit board can stand upright on the main circuit board, and wherein an edge connector is provided on the free edge of the sub-circuit board.

The circuit board assembly comprises a main circuit board and at least one sub-circuit board, the main circuit board and the at least one sub-circuit board can be constructed independently of each other and then electrically and mechanically connected to each other, for example. The electrical connection between the sub-circuit board and the main circuit board forms a conductive path between the sub-circuit board and the main circuit board, so that current or electrical signals can be transmitted between the sub-circuit board and the main circuit board.

Here, the sub-circuit board can stand upright on the main circuit board. That is, when the main circuit board is laid flat, the sub-circuit board is arranged basically vertically on the main circuit. By providing the sub-circuit board upright on the main circuit board, the circuit that originally needs to be arranged on the main circuit board can be partially relocate on the sub-circuit board, thereby effectively reducing the occupation area of the main circuit board and the structural space required for the circuit board assembly. This is particularly beneficial for application scenarios in which complex circuits need to be arranged in a limited space.

In addition, an edge connector is constructed on the free edge of the sub-circuit board. The edge connector is also called "edge-type connector" or gold finger, which can be understood as a group of metal contact points or connection structures. The edge connector is usually in the form of a protruding, elongated metal strip or metal point. The edge connector can be constructed, for example, on the free edge of the sub-circuit board so as to be connected to a corresponding interface such as a slot or a socket. By means of the edge connector arranged on the sub-circuit board, an electrical connection between the circuit board assembly and a device or component external to the circuit board assembly can be established. Specifically, the sub-circuit board itself can be connected to an external device via the edge connector, and thanks to the electrical connection between the sub-circuit board and the main circuit board, the main circuit board can also be electrically connected to the external device via the sub-circuit board through the edge connector. Therefore, the edge connector arranged on the sub-circuit board can be used as a connection interface between the entire circuit board assembly (including the sub-circuit board and the main circuit board) and the external device, thereby advantageously omitting the costly connection terminal or at least reducing the number of connection terminals in the entire circuit board assembly.

Therefore, on one hand, the circuit board assembly has a more compact configuration, which helps the circuit board assembly to develop towards miniaturization and weight reduction. On the other hand, the circuit board assembly can adopt the edge connector provided on the free edge of the sub-circuit board instead of the connection terminal as the interface for electrical connection with external devices, thereby having a lower production cost.

According to an embodiment of the invention, the edge connector is provided on the upper edge and/or the side edge of the sub-circuit board. Exemplarily, in the case where the sub-circuit board has a substantially rectangular profile, for example, the sub-circuit board can be connected to the main circuit board at its lower edge, and edge connectors can be provided on the other free edges of the sub-circuit board, i.e., the upper edge and the side edges. In some embodiments, one sub-circuit board can comprise only one edge connector. Without limiting thereto, in other embodiments, one sub-circuit board can comprise more than one edge connectors. For example, the upper edge and one side edge of a sub-circuit board can be provided with an edge connector, respectively.

According to an embodiment, the circuit board assembly comprises a housing, the main circuit board is laid flat in the housing, wherein the housing is filled with encapsulating material, wherein the edge connector of the sub-circuit board is not submerged by the encapsulating material. The circuit board assembly is particularly suitable for encapsulating using glue potting technology. The configuration in which the sub-circuit board can stand upright on the main circuit board allows the edge connector on the sub-circuit board to be raised relative to the main circuit board laid flat in the housing and thus the edge connector can be higher than the surface height of the filled encapsulating material. In this way, the circuit board assembly, especially the main circuit board, can be conveniently encapsulated with glue, while there is no need to costly provide additional protection for the edge connectors that are not desired to be encapsulated during the potting process. In addition, the encapsulating material can also advantageously surround and protect the connection area between the main circuit board and the sub-circuit board, enhance the connection strength between the sub-circuit board and the main circuit board, and ensure the reliability of the overall structure of the circuit board assembly.

According to an embodiment of the invention, the circuit board assembly comprises a plug connector matched with the edge connector of the sub-circuit board. Here, the plug connector ("plug bar") can be understood as an adapter between the edge connector of the sub-circuit board and the cable harness terminal of the external device, a pluggable connection can be achieved between the edge connector of the sub-circuit board and the cable harness terminal of the external device through the plug connector. In this embodiment, the circuit board assembly itself already includes a plug connector, the edge connector of the sub-circuit board is inserted into the plug connector and can be fixedly connected to the plug connector if necessary. As a result, the connection between the circuit board assembly and the external device can be established or disconnected by simply plugging or unplugging the corresponding cable harness terminal of the external device into/from the plug connector. The plug connector makes the use and montage of the circuit board assembly simpler and more flexible.

According to an embodiment of the invention, the circuit board assembly also comprises a sub-circuit board without edge connector. Such a sub-circuit board can also be electrically connected to the main circuit board, and can be used, for example, to carry a portion of the circuit of the main circuit board, such as a portion of the circuit functional unit, the circuit functional unit can communicate or cooperate with the circuit portion located on the main circuit board via the electrical connection between the sub-circuit board and the main circuit board. Since such a sub-circuit board has no edge connector, said sub-circuit board may not undertake the function of the connection interface between the circuit board assembly and the external device. However, it can also be conceived that other forms of connection interfaces, such as wire-to-board connectors, are provided on the sub-circuit board to achieve connection with external devices.

According to an embodiment of the invention, circuit component(s) can be arranged on the sub-circuit board. Such circuit elements are, for example, surface mounted components and/or plug-in elements with light weight or small volume, such as resistors, inductors, SCR (Silicon Controlled Rectifier) protection devices, capacitors, etc. Thus, additional available space for arranging circuit elements can be provided by the sub-circuit board, thereby further reducing the size of the main circuit board on one hand, and allowing more diverse circuit designs and layouts on the other hand.

According to an embodiment of the invention, the circuit board assembly comprises at least two sub-circuit boards, wherein the at least two sub-circuit boards are arranged at an angle to each other, so that a carrying area for circuit component(s) is formed between the at least two sub-circuit boards. Exemplarily, the circuit board assembly may comprise two sub-circuit boards that are arranged close to each other, especially arranged directly against each other, and the two sub-circuit boards stand upright on the main circuit board in a manner perpendicular to each other. Compared with an individual sub-circuit board, the arrangement of the two circuit boards at an angle to each other makes the corner area or support area between the two circuit boards have a relatively high load-bearing capacity, so that in such a support area, circuit elements with a greater weight and/or volume (such as transformers, relays, reactors, etc.) can be arranged on the two circuit boards and especially suspended relative to the main circuit board. Here, the two sub-circuit boards can together constitute a support structure or a rack, and even circuit elements with a greater weight and/or volume can be arranged on such a support structure or rack, thereby further enriching the possibilities of circuit design and layout.

According to an embodiment of the invention, the circuit board assembly comprises at least three sub-circuit boards, wherein the at least three sub-circuit boards enclose an isolation area which is closed relative to the encapsulating material. For example, components that are not expected to be covered by the encapsulating material, such as plug-in slots, etc., can be arranged in such an isolation area. This can further enrich the possibilities of circuit design and layout.

According to an embodiment of the invention, a sealing element is provided between the sub-circuit boards enclosing the isolation area, and/or a sealing element is provided between the sub-circuit boards enclosing the isolation area and the main circuit board. The sealing element can be, for example, sealant or sealing strip.

According to an embodiment of the invention, the sub-circuit board is configured with a plug-in portion, and the main circuit board comprises connecting hole(s) for inserting the plug-in portion.

According to an embodiment of the invention, electrically conductive materials are applied to the plug-in portion and the connecting hole(s) respectively. The electrical connection between the sub-circuit board and the main circuit board is achieved through the electrically conductive materials.

According to an embodiment of the invention, the electrically conductive materials on the plug-in portion and the connecting hole(s) are welded to each other, in particular through a wave soldering process.

According to an embodiment of the invention, the plug-in portion is composed of a plurality of plug-in teeth, each plug-in tooth is inserted into a corresponding connecting hole.

According to an embodiment of the invention, the plug-in portion is configured as a connecting plate, and the connecting hole is configured as a connecting slot. According to an embodiment of the invention, the circuit board assembly comprises a sub-circuit board support element. By providing the sub-circuit board support element, additional support can be provided for the sub-circuit board to prevent the sub-circuit board from loosening or breaking. Exemplarily, the sub-circuit board support element can be constructed in the form of an L-shaped or triangular element.

According to an embodiment of the invention, the main circuit board is configured with a plug-in portion on the edge, and the sub-circuit board is configured with connecting hole(s) for inserting said plug-in portion. In this embodiment, the main circuit board and the sub-circuit board can be connected to each other by inserting the plug-in portion constructed on the edge of the main circuit board into the corresponding connecting hole(s) of the sub-circuit board.

According to an embodiment of the invention, another sub-circuit board is provided on the sub-circuit board. In this way, a three-dimensional topology of the circuit board assembly can be achieved, thereby further enriching the possibilities of circuit design and layout.

A second aspect of the present invention relates to a household appliance, which comprises the circuit board assembly according to the first aspect of the present invention.

Further features can be found in the figures and the concrete embodiments. The features and combinations of features which have been mentioned above in the description and the features and combinations of features which are mentioned below in the description of the concrete embodiments and/or presented only in the figures can be used not only in the respectively specified combination but also in other combinations or alone.
Fig. 1 schematically shows an exploded view of a circuit board assembly according to an embodiment of the present invention;
Fig. 2 schematically shows the main circuit board and the sub-circuit board of the circuit board assembly;
Fig. 3 schematically shows the main circuit board and the sub-circuit board from another perspective;
Fig. 4 schematically shows a partial view of the circuit board assembly, wherein the sub-circuit board has not yet been connected to the main circuit board;
Fig. 5 schematically shows a partial enlarged view of the rear of the main circuit board;
Fig. 6 schematically shows a perspective view of the circuit board assembly according to Fig. 1;
Fig. 7 schematically shows the circuit board assembly after glue potting;
Fig. 8 schematically shows a perspective view of a circuit board assembly according to another embodiment of the present invention.

The present invention will be described below with reference to the attached drawings, wherein the attached drawings illustrate certain embodiments of the present invention. However, it should be understood that the present invention may be presented in many different ways and is not limited to the embodiments described below; in fact, the embodiments described below are intended to make the disclosure of the present invention more complete and to fully explain the protection scope of the present invention to those skilled in the art. It should also be understood that the embodiments disclosed in the present disclosure may be combined in various ways so as to provide more additional embodiments.

It should be understood that the terms used herein are only used to describe specific embodiments, and are not intended to limit the scope of the present invention. All terms used herein (including technical terms and scientific terms) have meanings normally understood by those skilled in the art unless otherwise defined. For brevity and/or clarity, well-known functions or structures may not be further described in detail.

As used herein, the term "A or B" comprises "A and B" and "A or B", not exclusively only "A" or only "B", unless otherwise specified.

As used herein, the term "exemplary" means "serving as an example, instance or explanation". Any realization method described exemplarily herein may not be necessarily interpreted as being preferable or advantageous over other realization methods. Furthermore, the present invention is not limited by any expressed or implied theory given in the above technical field, background art, summary of the invention or embodiments.

It will be further understood that the term "include/comprise," when used herein, specify the presence of stated features, entireties, steps, operations, units, and/or components, but do not preclude the presence or addition of one or more other features, entireties, steps, operations, units and/or components, and/or a combination thereof. Unless otherwise defined, all terms (including technical and scientific terms) are used herein in their ordinary meaning of the art to which the examples belong.

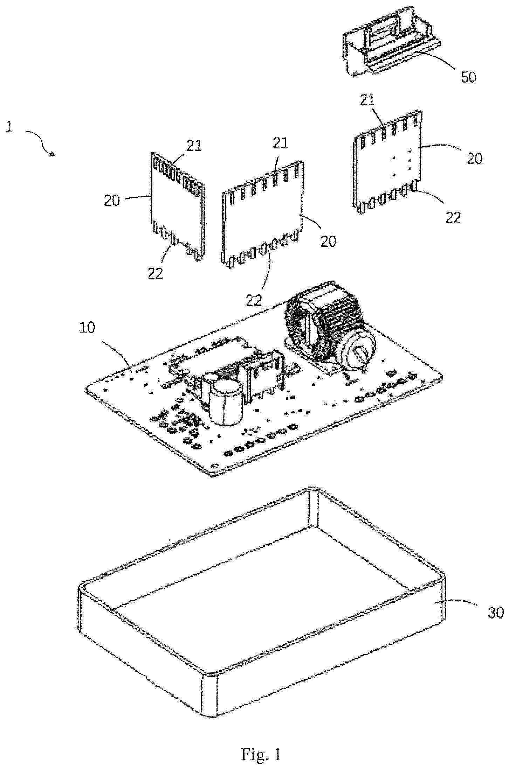

Fig. 1 shows an exploded view of a circuit board assembly 1 according to an embodiment. The circuit board assembly 1 comprises a main circuit board 10 and at least one sub-circuit board 20, wherein the main circuit board 10 and the at least one sub-circuit board 20 are electrically and mechanically connected to each other, the sub-circuit board 20 can stand upright on the main circuit board 10, and an edge connector 21 is provided on the free edge of the sub-circuit board 20.

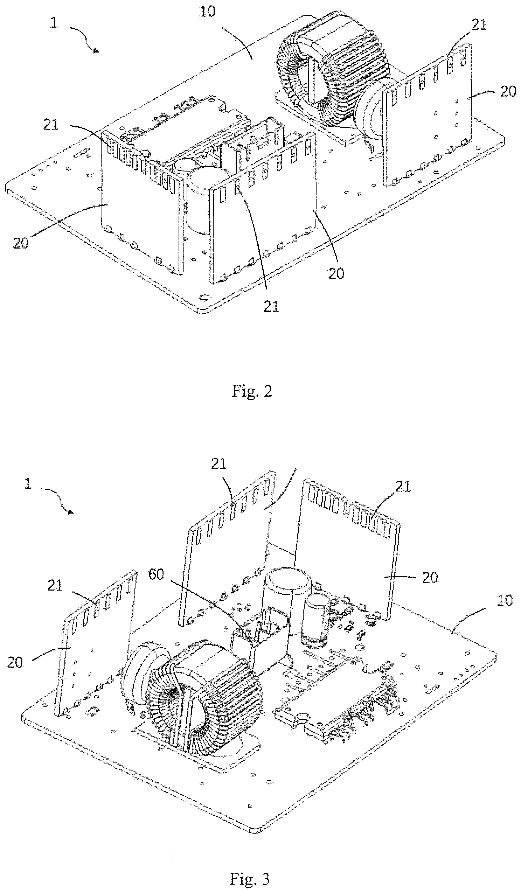

As can be most clearly seen in Figs. 2 and 3, when the main circuit board 10 is placed flat or horizontally, the sub-circuit board 20 is vertically arranged on the main circuit board 10, so that the sub-circuit board 20 is approximately perpendicular to the main circuit board 10. By providing the sub-circuit board 20, the circuit that originally needs to be arranged on the main circuit board 10 can be partially transferred to the sub-circuit board 20. For example, circuit elements (not shown) can also be arranged on the sub-circuit board 20. Advantageously, the circuit elements arranged on the sub-circuit board 20 can be surface mounted elements and/or plug-in elements, such as resistors, inductors, SCR protection devices, capacitors, etc. By making the sub-circuit board 20 stand up relative to the main circuit board 10, the occupied area of the circuit elements on the main circuit board 10 and the structural space required for the circuit board assembly 1 as a whole can be effectively reduced. This is particularly beneficial for application scenarios where complex circuits need to be arranged in a limited space.

In addition, as shown in Figs. 1-3, the sub-circuit board 20 can be in contact with and connected to the main circuit board 10 at its first end 22 at the bottom, and the second end or upper end of the sub-circuit board 20 opposite to the first end 22 can be configured with an edge connector 21. Through the edge connector 21 arranged on the sub-circuit board 20, an electrical connection between the circuit board assembly 1 and a device or component (not shown) external to the circuit board assembly 1 can be established. To be specific, the sub-circuit board 20 itself can be connected to a not-shown external device via the edge connector 21, and based on the electrical connection between the sub-circuit board 20 and the main circuit board 10, the main circuit board 10 can also be electrically connected to the external device via the sub-circuit board 20 through the edge connector 21. As a result, the edge connector 21 arranged on the sub-circuit board 20 can be used as a connection interface between the entire circuit board assembly 1 and the external device, thereby advantageously omitting the costly connection terminals or at least reducing the number of connection terminals in the entire circuit board assembly 1.

Not limited to the illustrated embodiment, the edge connector 21 may also be configured on the side edge of the sub-circuit board 20. For example, the sub-circuit board 20 may comprise a laterally protruding portion for carrying the edge connector 21. In addition, more than one edge connector 21 can be provided on one sub-circuit board 20.

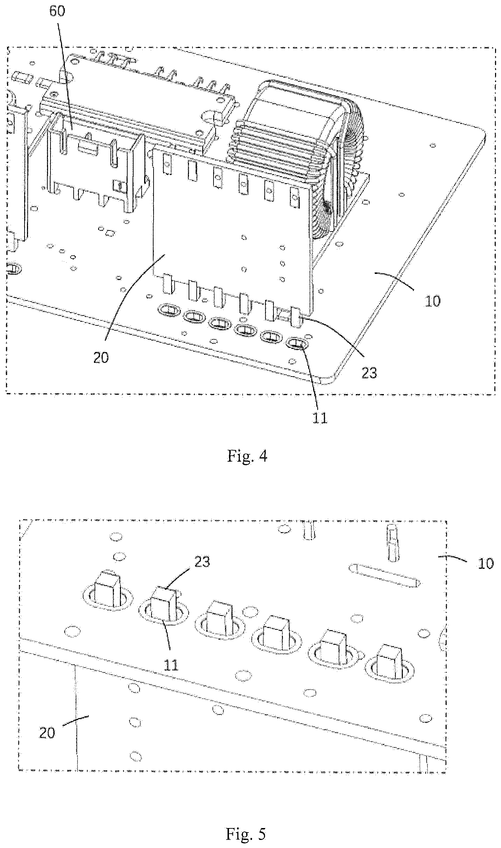

Regarding the connection between the sub-circuit board 20 and the main circuit board 10, in some embodiments, the sub-circuit board 20 may be provided with a plug-in portion on the lower side, and the main circuit board 10 may comprise connecting hole(s) for inserting the plug-in portion of the sub-circuit board 20. Electrically conductive materials may be applied to the plug-in portion and the connection hole(s), respectively. To be specific, as shown in Figs. 4-5, in some embodiments, the plug-in portion of the sub-circuit board 20 may be composed of a plurality of plug-in teeth 23, the plurality of plug-in teeth 23 may be arranged in a tooth-like shape or a comb-like shape. Correspondingly, the main circuit board 10 may have a plurality of connection holes 11, and each connection hole 11 may be matched with a plug-in tooth 23, respectively. For the sake of clarity, only one plug-in tooth 23 and one corresponding connection hole 11 are equipped with reference signs. After the plug-in teeth 23 of the sub-circuit board 20 are inserted into the corresponding connecting holes 11, the electrically conductive material on the plug-in teeth 23 can be welded with the electrically conductive material on the periphery of the corresponding connecting holes 11, especially by wave soldering process, thereby realizing reliable electrical connection between the sub-circuit board 20 and the main circuit board 10.

In some embodiments, conductive material may be disposed on all the plug-in teeth 23 and all the connecting holes 11. Thus, electrical connection between the main circuit board 10 and the sub-circuit board 20 may be formed between all the plug-in teeth 23 and the corresponding connecting holes 11. In other embodiments, conductive material may be disposed only on some of the plug-in teeth 23 and on the connecting holes 11 corresponding to these plug-in teeth 23. Thus, electrical connection is formed only between some of the plug-in teeth 23 and the connecting holes 11, while other plug-in teeth 23 and corresponding connecting holes 11 not disposed with conductive material may be used only for mechanical connection between the main circuit board 10 and the sub-circuit board 20.

In an embodiment not shown, the plug-in portion of the sub-circuit board 20 may be configured as a connecting plate, the connecting plate may extend longitudinally along the edge of the sub-circuit board 20. Correspondingly, the connecting hole 11 of the main circuit board 10 may be configured as an elongated connecting slot.

In an embodiment not shown, the plug-in portion can be constructed in the edge region of the main circuit board 10, and the connecting hole(s) can be constructed on the sub-circuit board 20, in particular, in the lower region of the sub-circuit board 20. The plug-in portion can be inserted into the connecting hole(s), and the plug-in portion and the connecting hole(s) can be fixedly connected to each other, for example, by a welding process. Thus, the main circuit board 10 and the sub-circuit board 20 are connected in a manner that the main circuit board 10 is plugged into the sub-circuit board 20.

In an embodiment not shown, the circuit board assembly 1 may include a sub-circuit board support element. The sub-circuit board support element may be, for example, arranged in the region of the angle formed by the sub-circuit board 20 and the main circuit board 10. The sub-circuit board support element may, for example, have an L-shaped basic form, one leg of the L-shaped sub-circuit board support element being abutted against or fixed on the sub-circuit board 20, while the other leg of the L-shaped sub-circuit board support element being abutted against or fixed on the main circuit board 10. Alternatively, the sub-circuit board support element may as well, for example, have a triangular basic form, one side of the triangular sub-circuit board support element may be abutted against or fixed on the sub-circuit board 20, while the other side of the triangular sub-circuit board support element may be abutted against or fixed on the main circuit board 10. By providing the sub-circuit board support element, additional support can be provided for the sub-circuit board 20, effectively preventing the sub-circuit board 20 from being loosened or broken.

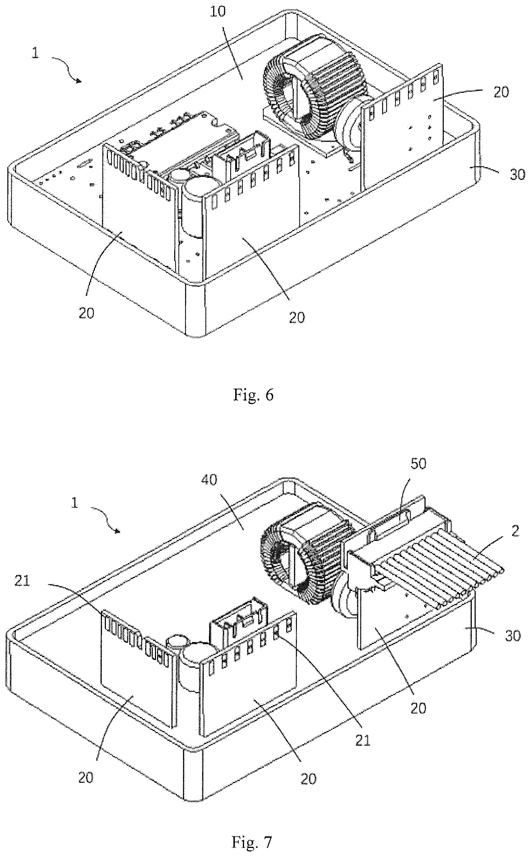

For example, in the case where the circuit board needs to be potted and encapsulated to protect against environmental influences, as shown in Fig. 6, the circuit board assembly 1 may comprise a housing 30, the main circuit board 10 is arranged flat in the housing 30. The housing 30 can protect the circuit board located therein, and can be used to carry and accommodate the encapsulating material 40 during potting (see Fig. 7). Fig. 7 shows the circuit assembly 1 after potting in the housing 30. It can be seen that, because the sub-circuit board 20 stands upright on the main circuit board 10, the edge connector 21 constructed on the sub-circuit board 20 is completely outside the encapsulating material 40, or in other words, the encapsulating material 40 does not immerse the edge connector 21 of the sub-circuit board 20. Therefore, even after potting, the edge connector 21 can still be used to connect to an external device without any problem. In addition, the cured encapsulating material 40 can also further strengthen the connection between the sub-circuit board 20 and the main circuit board 10, enhancing the stability of the entire circuit board assembly 1.

Continuing to refer to Fig. 7, the circuit board assembly 1 may further comprise a plug connector 50 matched with the edge connector 21 of the sub-circuit board 20, and the plug connector 50 may be plugged and connected with the corresponding edge connector 21. Thus, the connection between the circuit board assembly 1 and the external device (not shown) can be established or disconnected by simply plugging or unplugging the corresponding cable harness terminal 2 of the external device into or from the plug connector 50. The presence of the plug connector 50 makes the use and montage of the circuit board assembly 1 simpler and more flexible. For the sake of clarity, only one plug connector 50 plugged into the sub-circuit board 20 is shown here.

In addition, as can be most clearly seen in Figs. 3-4, a connection terminal 60, in particular a high voltage connection terminal 60, can be provided on the main circuit board 10. The power supply voltage of the circuit board assembly 1, for example, a power supply voltage of 220V or 250V, can be provided through the high voltage connection terminal 60. The edge connector 21 constructed on the sub-circuit board 20 can, for example, only be used to achieve low voltage connection for transmitting, for example, control signals, sensor signals, communication signals, etc. This embodiment can achieve isolation between high voltage and low voltage, which helps to ensure the safety and reliability of the circuit system. In an embodiment not shown, the power supply voltage of the circuit board assembly 1 can also be provided via the edge connector 21 constructed on the sub-circuit board 20, which is particularly suitable for the case where the power supply voltage of the circuit board assembly 1 is relatively low.

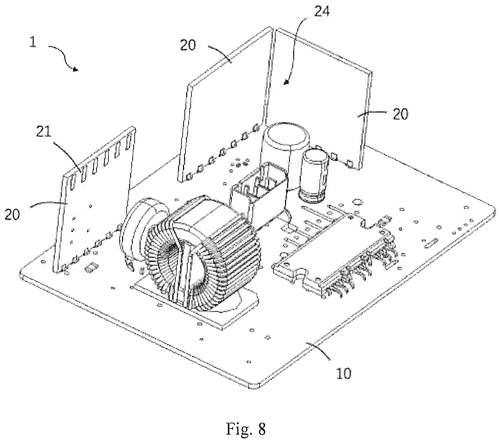

Fig. 8 schematically shows a perspective view of a circuit board assembly 1 according to another embodiment of the invention. Here, three sub-circuit boards 20 are arranged on a main circuit board 10, wherein only one sub-circuit board 20 is configured with an edge connector 21, while the other two sub-circuit boards 20 do not have edge connectors.

In an embodiment not shown, the circuit board assembly 1 may further include a sub-circuit board, which is electrically isolated from the main circuit board 10 and there is an edge connector provided on said sub-circuit board 20. Here, although the sub-circuit board electrically isolated from the main circuit board 10 is also arranged on the main circuit board 10 and mechanically connected to the main circuit board 10, such a sub-circuit board is not in electrical contact with the main circuit board 10. The sub-circuit board electrically isolated from the main circuit board 10 may, for example, have its own complete circuit function and operate independently of the main circuit board. An edge connector is provided on the sub-circuit board electrically isolated from the main circuit board 10, so that the sub-circuit board can be powered or communicate with an external device via the edge connector. Of course, since such a sub-circuit board is not electrically connected to the main circuit board 10, its edge connector is not used as a connection interface between the main circuit board 10 and the external device. It should be understood that, although the sub-circuit board electrically isolated from the main circuit board 10 itself is not directly electrically connected to the main circuit board, communication between the main circuit board 10 and such a sub-circuit board is still possible, which can be realized, for example, by means of wireless communication or indirectly through an external device.

Continuing to refer to Fig. 8, the two sub-circuit boards 20 (here, the two sub-circuit boards 20 without edge connector) of the circuit board assembly 1 are arranged at an angle relative to each other (here perpendicular to each other) and are arranged close to each other, such that a support area 24 with relatively high load-bearing capacity is formed between the two sub-circuit boards 20. Thanks to the relatively high load-bearing capacity of the support area 24, circuit elements (such as transformers, relays, reactors, etc.) with a greater weight and/or volume that are not shown can be arranged in the support area 24 between the two circuit boards 20. In particular, the circuit elements with a greater weight and/or volume can be suspended relative to the main circuit board 10, so that below such circuit elements with a greater weight and/or volume, other circuit elements can still be arranged on the main circuit board 10. Although the two sub-circuit boards 20 forming the support area 24 exemplarily shown in Fig. 8 do not have the edge connector 21, it should be understood that the sub-circuit boards 20 forming the support area 24 may also comprise the edge connector 21. In order to arrange the plug connector 50 on the edge connector 21 without any problem, it can be conceived that the corresponding edge connector 21 is provided, for example, on the side edge of the sub-circuit board 20 that is remote from the support area 24. It is also conceivable that the sub-circuit boards 20 have different heights and the edge connector 21 is constructed on the upper edge of the edge connector 21 with the greater height. In an embodiment not shown, the circuit board assembly 1 may comprise at least three sub-circuit boards 20, and the at least three sub-circuit boards 20 enclose an isolation area that is closed relative to the encapsulating material 40. In such an isolation area, for example, components, such as plug-in slots, etc., that are not expected to be covered by the encapsulating material 40 can be arranged. Alternatively, it is also possible that only the isolation area is filled with the encapsulating material 40, so that the encapsulating material 40 can specifically be used to protect the components located in the isolation area. If necessary, a sealing element can be provided between the sub-circuit boards 20 enclosing the isolation area, and/or a sealing element can be provided between the sub-circuit boards 20 enclosing the isolation area and the main circuit board 10, so as to prevent the encapsulating material 40 from entering the isolation area or flowing out of the isolation area. This can further enrich the possibilities of circuit design and layout.

In other embodiments not shown, another sub-circuit board may be arranged on the sub-circuit board 20, forming a three-dimensional topology of the circuit board assembly 1. This can further enrich the possibilities of circuit design and layout.

In an embodiment not shown, the household appliance may, for example, comprise the circuit board assembly 1.

The present invention is not limited to the illustrated embodiments but embraces or extends to all variants and technical equivalents which can fall within the scope of the accompanying claims. The positional references adopted in the description such as for example "up", "down", "left", "right" and so forth are also related to the usual position of installation of the components used and to the illustrated Figure and are to be appropriately transferred to the new position upon a change in position.

Although the present invention has been disclosed with the above preferred embodiment, the embodiment is not intended to limit the present invention. Those skilled in the art can amend and modify the above disclosed technical content as equivalent embodiments with equivalent variation, without departing from the scope of the technical solution of the present invention. However, the contents without departing from the technical solution of the present invention, any of simple amendments, equivalent variations and modifications for the above embodiments based on the technical essence of the present invention, should fall into the scope of the technical solution of the present invention.

## Claims

1. A circuit board assembly, **characterized in that** the circuit board assembly (1) comprises a main circuit board (10) and at least one sub-circuit board (20), wherein the main circuit board and the at least one sub-circuit board are electrically and mechanically connected to each other, the sub-circuit board can stand upright on the main circuit board, and wherein an edge connector (21) is provided on the free edge of the sub-circuit board.

2. Circuit board assembly according to claim 1, **characterized in that** the edge connector is provided on the upper edge and/or the side edge of the sub-circuit board.

3. Circuit board assembly according to claim 1 or 2, **characterized in that** the circuit board assembly comprises a housing (30), the main circuit board is laid flat in the housing, wherein the housing is filled with encapsulating material (40), wherein the edge connector of the sub-circuit board is not submerged by the encapsulating material.

4. Circuit board assembly according to claim 1 or 2, **characterized in that** the circuit board assembly comprises a plug connector (50) matched with the edge connector of the sub-circuit board.

5. Circuit board assembly according to claim 1 or 2, **characterized in that** circuit component(s) can be arranged on the sub-circuit board.

6. Circuit board assembly according to claim 1 or 2, **characterized in that** the circuit board assembly comprises at least two sub-circuit boards, wherein the at least two sub-circuit boards are arranged at an angle to each other, so that a carrying area (24) for circuit component(s) is formed between the at least two sub-circuit boards.

7. Circuit board assembly according to claim 3, **characterized in that** the circuit board assembly comprises at least three sub-circuit boards, wherein the at least three sub-circuit boards enclose an isolation area which is closed relative to the encapsulating material.

8. Circuit board assembly according to claim 7, **characterized in that** a sealing element is provided between the sub-circuit boards enclosing the isolation area, and/or a sealing element is provided between the sub-circuit boards enclosing the isolation area and the main circuit board.

9. Circuit board assembly according to claim 1 or 2, **characterized in that** the sub-circuit board is configured with a plug-in portion, and the main circuit board comprises connecting hole(s) for inserting the plug-in portion.

10. Circuit board assembly according to claim 9, **characterized in that** electrically conductive materials are applied to the plug-in portion and the connecting hole(s) respectively.

11. Circuit board assembly according to claim 10, **characterized in that** the electrically conductive materials on the plug-in portion and the connecting hole(s) are welded to each other.

12. Circuit board assembly according to claim 9, **characterized in that** the plug-in portion is composed of a plurality of plug-in teeth (23), each plug-in tooth is inserted into a corresponding connecting hole (11); or that the plug-in portion is configured as a connecting plate, and the connecting hole is configured as a connecting slot.

13. Circuit board assembly according to claim 1 or 2, **characterized in that** the main circuit board is configured with a plug-in portion on the edge, and the sub-circuit board is configured with connecting hole(s) for inserting said plug-in portion.

14. Circuit board assembly according to claim 1 or 2, **characterized in that** another sub-circuit board is provided on the sub-circuit board.

15. A household appliance, **characterized in that** the household appliance comprises the circuit board assembly according to any one of claims 1 to 14.
